# EUROPEAN PATENT APPLICATION

(11) **EP 2 960 924 A1**
(43) Date of publication of application: **30.12.2015**
(21) Application number: 15173248.4
(22) Date of filing: 23.06.2015
(51) Int. Cl.: H01J 37/305, H01J 37/317

(54) **METHOD AND SYSTEM OF CREATING SYMMETRICAL FIB DEPOSITION**

(30) Priority: 24.06.2014 US 201462016464 P; 27.10.2014 US 201414524315
(71) Applicant: FEI Company, Hillsboro, OR 97124-5793 (US)
(72) Inventor: Fuller, Scott, Portland, OR Oregon 97219 (US); Sidorov, Oleg, Hillsboro, OR Oregon 97124 (US)
(74) Representative: Bakker, Hendrik

(57) **Abstract**

A system is provided to produce symmetric depositions using a charged-particle beam deposition with an angled beam. In the past, the use of an FIB with non-orthogonal incidence angles produced depositions that grew toward the FIB beam path making it difficult to produce uniformity of the deposit. With the current invention, a symmetrical deposition is made even with the use of a non-orthogonal FIB.

## Description

This application claims priority from U.S. Prov. Pat. App. No. 62/016,464, filed June 24, 2014, which is hereby incorporated by reference.

### Technical Field of the Invention

The present invention relates to charged particle beam-induced deposition and more specifically to deposition processes in which the beam is not orthogonal to the work piece surface.

### Background of the Invention

Monitoring nanometer scale processes, such as the photolithography processes used in the fabrication of integrated circuits, is challenging. To fabricate integrated circuits, a semiconductor substrate, such as silicon wafer, on which circuits are being formed is coated with a material, such as a photoresist, that changes solubility when exposed to radiation. A lithography tool, such as a mask or reticle, positioned between the radiation source and the semiconductor substrate casts a shadow to control which areas of the substrate are exposed to the radiation. After the exposure, the photoresist is removed from either the exposed or the unexposed areas, leaving a patterned layer of photoresist on the wafer that protects parts of the wafer during a subsequent etching or diffusion process.

During the manufacturing process, variations in exposure and focus require that the patterns developed by lithographic processes be continually monitored or measured to determine if the dimensions of the patterns are within acceptable ranges. The importance of such monitoring, often referred to as process control, increases considerably as pattern sizes become smaller, especially as minimum feature sizes approach the limits of resolution available by the lithographic process. In order to achieve ever-higher device density, smaller and smaller feature sizes are required. This may include the width and spacing of interconnecting lines, spacing and diameter of contact holes, and the surface geometry such as corners and edges of various features. Features on the wafer are three-dimensional structures and a complete characterization must describe not just a surface dimension, such as the top width of a line or trench, but a complete three-dimensional profile of the feature. Process engineers must be able to accurately measure the critical dimensions (CD) of such surface features to fine tune the fabrication process and assure a desired device geometry is obtained.

Typically, CD measurements are made using instruments such as a scanning electron microscope (SEM). In a scanning electron microscope (SEM), a primary electron beam is focused to a fine spot that scans the surface to be observed. Secondary electrons are emitted from the surface as it is impacted by the primary beam. The secondary electrons are detected, and an image is formed, with the brightness at each point of the image being determined by the number of secondary electrons detected when the beam impacts a corresponding spot on the surface. As features continue to get smaller and smaller, however, there comes a point where the features to be measured are too small for the resolution provided by an ordinary SEM.

Transmission electron microscopes (TEMs) allow observers to see extremely small features, on the order of nanometers. In contrast to SEMs, which only image the surface of a material, TEMs also allow analysis of the internal structure of a sample. In a TEM, a broad beam impacts the sample and electrons that are transmitted through the sample are focused to form an image of the sample. The sample must be sufficiently thin to allow many of the electrons in the primary beam to travel though the sample and exit on the opposite site. Samples, also referred to as lamellae, are typically less than 100 nm thick.

In a scanning transmission electron microscope (STEM), a primary electron beam is focused to a fine spot, and the spot is scanned across the sample surface. Electrons that are transmitted through the sample are collected by an electron detector on the far side of the sample, and the intensity of each point on the image corresponds to the number of electrons collected as the primary beam impacts a corresponding point on the surface.

Because a sample must be very thin for viewing with transmission electron microscopy (whether TEM or STEM), preparation of the sample can be delicate, time-consuming work. The term "TEM" as used herein refers to a TEM or an STEM and references to preparing a sample for a TEM are to be understood to also include preparing a sample for viewing on an STEM. The term "S/TEM" as used herein also refers to both TEM and STEM.

A focused ion beam (FIB) system can be used to form lamellae for observation on a TEM. One process for preparing lamellae is described in U.S. Pat. Pub. 2013/319,849 A1 for "Preparation of Lamellae for TEM Viewing," which is assigned to the application of the present invention and which is hereby incorporated by reference. FIB systems are widely used in microscopic-scale manufacturing operations because of their ability to image, etch, mill, deposit, and analyze very small structures with great precision. FIB systems produce a narrow, focused beam of ions that is typically scanned across the surface of a sample in a raster fashion. In many commercial FIB systems, positively charged gallium ions (Ga+) are extracted from a liquid metal ion source. In some systems, other ion species, such as argon or xenon, are extracted from a plasma ion source. The extracted ions are accelerated, collimated, and focused onto a sample by a series of apertures and electrostatic lenses. The ion beam can be used to remove material from the sample surface or to deposit material onto the surface. When used to remove material, often referred to as etching or milling, the ions in the focused ion beam physically eject atoms or molecules from the surface by sputtering, that is, by a transfer of momentum from the incoming ions to the atoms at the surface.

When used to deposit material with a FIB, a precursor gas, such as tungsten hexacarbonyl or styrene gas, is directed onto the sample surface, usually via a fine needle inserted near the position of the ion beam. The gas is broken down into volatile and non-volatile components when the ion beam strikes the surface. The non-volatile component is deposited onto the surface, while the volatile component is pumped away.

Because FIB milling can cause significant damage to small structures, the work piece surface is often coated with a protective layer of tungsten or carbon before milling begins. The protective layer can be deposited using ion beam-induced deposition. To reduce artifacts on the lamella that interfere with TEM imaging, the protective layer should be symmetrical.

As used here, the term "angle of incidence" or "incidence angle" refers to the tilt of the beam axis relative to a normal to the surface to which the beam is directed. That is, the angle of incidence of a beam perpendicular to the surface is zero. In some systems, FIB column axes are oriented at a small angle, such as +/- 3 degrees, from a normal to the sample surface. Such systems can apply a relatively symmetrical deposition. Other FIBs use an FIB column axis oriented at 45 degrees to the sample surface. Applicants have found that when the ion beam is not oriented normal to the work piece surface, the deposition tends to be asymmetrical.

SEM deposition of the protective layer can be used to protect sensitive surfaces from FIB damage, but this can lead to lamella placement issues unless a recognizable mark is visible to the FIB after the feature of interest has been covered with SEM deposition.

Applicants investigated, researched, and discovered a method that improves the FIB induced deposition using specific operating conditions that produce symmetrical growth using a non-orthogonal beam, which technique is particularly useful for depositing a protective layer or cap during lamella formation.

### Summary of the Invention

It is an object of the invention, therefore, to provide symmetrical charged particle beam-induced deposition when using a charged particle beam that is incident at a non-normal angle to the work piece surface.

The invention provides a method and apparatus for producing symmetric beam-induced deposition with an incident beam that is not orthogonal to the work piece surface. In one embodiment, the system and methods can be used to form a protective layer as part of a process of forming a lamella for viewing on a transmission electron microscope. A set of operational parameters, including, for example, beam energy and scan direction, is set to provide the symmetrical deposition.

In accordance with some embodiments, a FIB column is oriented at a non-orthogonal angle, such as 45 degrees, to the sample surface and the deposition parameters are set so that the FIB-deposited material is symmetrical.

The foregoing has outlined rather broadly the features and technical advantages of the present invention in order that the detailed description of the invention that follows may be better understood. Additional features and advantages of the invention will be described hereinafter. It should be appreciated by those skilled in the art that the conception and specific embodiments disclosed may be readily utilized as a basis for modifying or designing other structures for carrying out the same purposes of the present invention. It should also be realized by those skilled in the art that such equivalent constructions do not depart from the scope of the invention as set forth in the appended claims.

### Brief Description of the Drawings

For a more complete understanding of the present invention, and the advantages thereof, reference is now made to the following descriptions taken in conjunction with the accompanying drawings, in which:
FIG. 1 shows a prior art system showing a charged particle apparatus with a SEM oriented at 45 degree angle to the work piece surface.
FIG. 2 shows a prior art system having a FIB column oriented orthogonal to the work piece surface.
FIG. 3 shows a system having a FIB column and an SEM column oriented at 45 degrees to the work piece surface.
FIG. 4 shows an image of a non-symmetric deposition produced by a beam incident at a non-orthogonal incident angle and a transverse orientation to the deposit.
FIG. 5 shows an image of a rough non-symmetric deposition produced by a beam incident at a non-orthogonal incident angle and a parallel orientation to the deposit.
FIG. 6 shows four beam-induced carbon line deposits produced using four different beam incident angles, the beam having a parallel orientation to the deposit.
FIG. 7 shows schematically the effects of beam-induced deposition at a large angle of incidence, the beam having a parallel orientation to the deposit.
FIG. 8 shows four beam-induced deposits produced using different landing energies at a non-orthogonal incident angle, the beam having a parallel orientation to the deposit.
FIG. 9 shows four beam-induced deposits produced using a landing energy of 5 keV at a non-orthogonal incident angle, the beam having a parallel orientation to the deposit.
FIG. 10 shows a smooth lamella formation with no curtaining formed using a cap deposited in accordance an embodiment of the invention.
FIG. 11 shows a flow chart depicting a process for formation of a lamella.

The accompanying drawings are not intended to be drawn to scale. In the drawings, each identical or nearly identical component that is illustrated in various figures is represented by a like numeral. For purposes of clarity, not every component may be labeled in every drawing.

### Detailed Description of Preferred Embodiments

Preferred embodiments of the present invention are directed toward methods and apparatuses for improved beam-induced deposition with a beam that is not orthogonal to the work piece surface. Embodiments are particularly useful to provide improved control of the deposition of protective layers for lamella manufacture.

When a beam inducing a deposition is incident at a non-orthogonal angle to the work piece surface, the deposition tends to grow in the direction of the beam source instead of normal to the work piece surface, resulting in an asymmetrical deposit. This asymmetrical deposition adversely affects the quality of the subsequent milling steps through the deposited layer because regions with a thicker protective layer will etch more slowly. The asymmetrical deposition is thought to be caused by the mechanics of the beam-induced deposition process. During a focused ion beam deposition process, there is competition between deposition and sputtering, and the sputtering rate depends on the angle between the beam and the surface on which the beam in incident. Sputter rates increase as the angle of incidence increases. The deposition tends to grow faster at angles having lower sputtering rate. The larger the deviation of the beam incident angle from normality, the greater the tendency for the deposit to grow towards the beam source. The magnitude of this effect varies with the incident angle and with the deposition precursor. For example, applicants have found that when using with a carbon precursor for deposition, the asymmetry is significant at the incident angles greater than about 35 to 40 degrees.

Embodiments of the invention deposit material using a FIB at a non-orthogonal incident angle. In one dual beam system commercially available from FEI Company, the present applicant, a FIB column axis is oriented at 45 degrees from the vertical and an SEM is also typically at about 45 degree angle +/- 3 degrees from the vertical. In one system that has proven to be valuable for manufacturing sub -50 nm thick lamellae, the SEM and FIB are spaced about 90 degrees azimuthally from each other, with each column axis oriented about 45 degrees from the vertical and from the sample surface.

Carbon, deposited by beam-induced deposition, can be used as a protective layer to protect the region of interest during ion beam processing. Carbon is a hard material that can withstand the intensive ion beam irradiation and has a high deposition rate. These properties make carbon an ideal material for use as a protective layer during lamella fabrication. However, when deposited with a beam having a large incidence angle, the carbon deposit is asymmetric, which results in inconsistent milling below the non-uniform layer and therefore artifacts in the lamella. Organometallic precursors used to deposit metals contain carbon, and the material deposited by beam-induced decomposition of the precursor gas typically contains a large amount of carbon as well as the desired metal. By "carbon deposition" or "carbon precursor" is meant a deposition or precursor, such as styrene, that is used to deposit carbon, and not a metallic precursor that inadvertently deposits carbon.

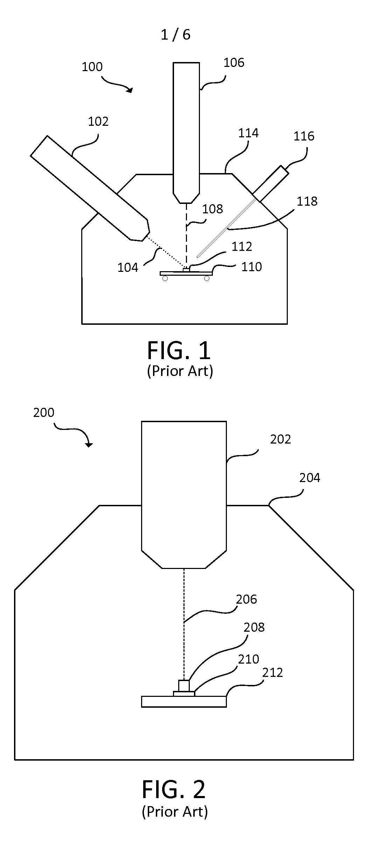

FIG. 1 shows a charged particle apparatus 100 equipped with a FIB column 102 for producing an ion beam 104 and a SEM column 106 for producing a beam of electrons 108. The SEM column is orthogonal to the sample surface. A sample stage 110 is equipped to hold a wafer or other work piece or sample and can typically move in the X-Y-Z directions, as well as rotate. Sample stage 110 may be tiltable so that the work piece can be oriented normal to either the electron beam or the ion beam. The sample stage is equipped to hold a work piece 112, such as a semiconductor wafer and or portion thereof. The stage is positioned in an evacuable sample chamber 114. A Gas Injection System (GIS) 116 with a metal needle 118 is used to provide a precursor gas at the sample surface. A sample mounted on the sample stage 110 can be machined by the focused ion beam 104 produced by the FIB column 102 and imaged using the focused beam of electrons 108.

FIG. 2 shows a system 200 having a FIB column 202 oriented vertically. The ion beam 206 impacts the sample at an orthogonal incident angle to a horizontal surface of the work piece 210 in a vacuum chamber 204. The work piece is held on a sample stage 212. The figure shows the work piece 210 with a layer 208 of beam-induced deposition being in a shape and direction that is oriented directly towards the column axis. The deposited layers of material stack symmetrically, one on top of the other.

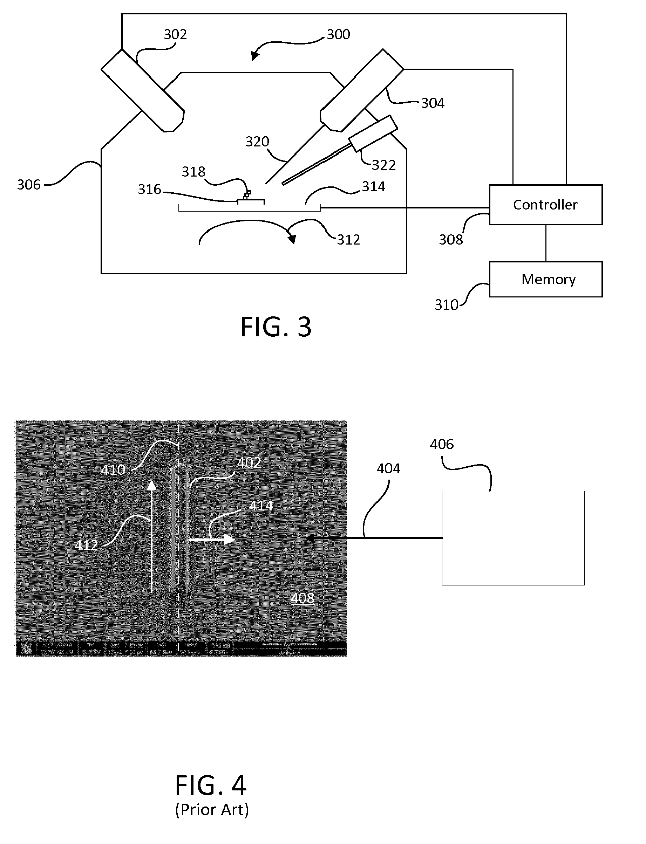

FIG. 3 shows a dual beam system 300 in which a beam-induced deposit 318 is being formed using an ion beam 320 having a beam-incident angle of about 45 degrees. In addition to an ion beam column 304, the apparatus also features an electron column 302 of a scanning electron microscope, both systems enclosed in a vacuum chamber 306. A controller 308 controls operation of the ion and electron beam systems, as well as rotational movement 312 of the sample stage 314. A gas injection system 322 provides a precursor gas near the workpiece surface. The controller is connected to controller memory 310, which stores instructions to be carried out by the various systems mentioned above, and in particular methods for carrying out the inventive processes described herein. The stacked layers of deposition 318 on the sample substrate 316 illustrate in an exaggerated way to show that at non-orthogonal incident angles, the FIB deposition tendency to grow toward the FIB and the material deposits asymmetrically.

The deposition of material and the sputtering of the deposited material are always competing with each other, as ions both decompose the precursor and knock materials form the surface. The balance between deposition and sputtering can be optimized toward deposition by selecting process parameters, such as gas pressure, beam current, beam energy, and ion species. Even with the beam parameters optimized to favor deposition over milling, the deposition is asymmetrical, which is detrimental for lamella TEM preparation. In the prior art, skilled persons have adjusted the operating parameters to maximize the deposition rate. Applicants have found that settings that do not maximize the deposition rate may be preferred, with the preferred parameters providing smoother or more symmetric depositions. The arrangement of this electron column 302 and FIB column 304 with a XY movable stage 314 that allows movement in the X-Y plane and rotation about an axis orthogonal to the X-Y plane is well suited for smooth and nanoscaled lamella production when used with a carbon based lamella protection layer. The FIB column 304 can include, for example, a liquid metal ion source, such as a source of gallium ions, a plasma ion source, such as an inductively coupled plasma ion source or an electron cyclotron resonance ion source, or any other source of ions that can be sufficiently directed to form a deposit of the desired resolution. The problem is that the asymmetric deposit formed by the angled beam adversely affects any lamella formed by milling through the asymmetric protective layer. The term "focused ion beam" as used herein includes a shaped beam, such as a beam that projects the shape of an aperture onto the work piece surface.

FIG. 4 shows an image of material 402 deposited with a focused ion beam 404 from a FIB column 406 at a landing energy of 30 kV on a work piece 408. The long axis 410 of the deposit is normal to the ion beam 404. That is, if the ion beam 404 were projected vertically onto a line on the work piece, the projected line is normal to the long axis of the deposit. This will be referred to as the deposit having a transverse orientation relative to the beam. The beam scans in direction 412, from bottom to top, parallel to the long axis 410, to form the deposit. The deposited material 402 is leaning towards the FIB as shown by arrow 414. This results in an asymmetrical shape that is detrimental to lamella fabrication processes that require symmetrical material removal from both sides of the lamella.

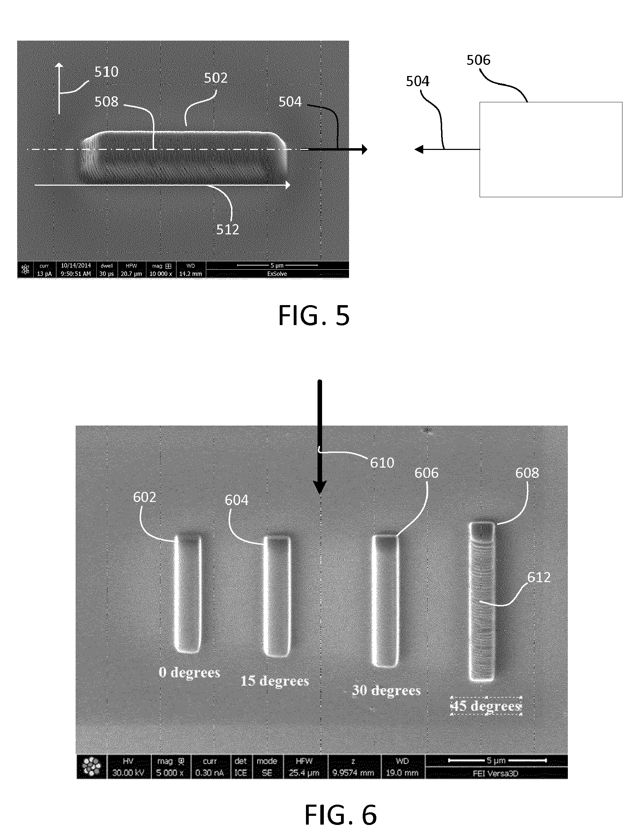

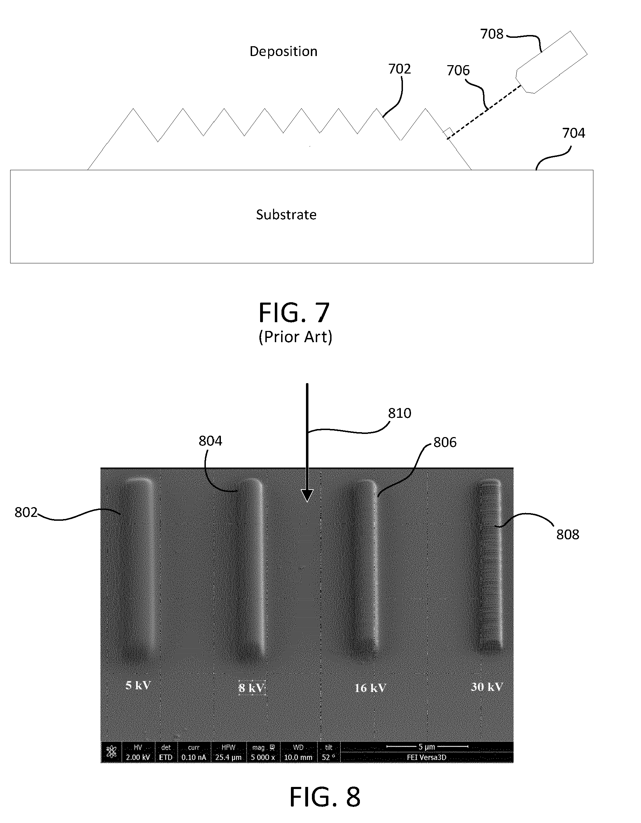

FIG. 5 shows an image of deposit 502 having a parallel orientation relative to the beam 504 from ion column 506. That is, if the beam were projected vertically onto a line on the work piece, the long axis 508 of the deposited material is parallel to the projected line. The beam 504 is typically scanned in direction 512, that is, across the long dimension of the deposit. Rather than the deposit being inclined to one side of the long axis 508 as the deposit of FIG. 4, the deposit of FIG. 5 forms ridges, as shown schematically in FIG. 7.

FIG. 6 shows lines of carbon deposition, each line deposit formed at a different incident angle of a 30kV Ga+ focused ion beam, with the beam having a parallel orientation relative to the longitudinal axis of the deposit. The beam was directed from direction 610. Deposit 602 is formed at an incident angle of 0 degrees, and because the FIB in this case is directly over the sample, the deposit 602 can be seen as being very smooth. The deposit 604 formed at a 15 degree incident angle is also smooth and symmetric. The deposit 606 is formed at a 30 degree incident angle of the FIB shows a much rougher surface, and the image 608, which is formed at a 45 degree angle, shows the deposit to have a very rough surface with visible ridges 612. The surface is so unsymmetrical, that when used a protective layer during lamella formation, the lamella has unacceptable artifacts. The ridges shown transfer down to the lamella to produce curtaining artifacts.

FIG. 7 shows schematically how the ridges 702 are formed at high angles of incidence against the work piece 704. The deposit tends to grow faster at surfaces that are normal to ion beam 706 and ion column 708 because the ion beam 706 etches less during deposition. Other areas are either masked by the high deposit rate regions or sputtered away, resulting in a rough surface.

Table 1 shows TRIM simulation results of carbon sputter rate from Ga+ beams having different energies at different incidence angles.

**TABLE 1**

| **CARBON SPUTTER RATE (atoms/ion WITH Ga+ BEAM AT DIFFERENT INCIDENT ANGLES** | | | | |
|---|---|---|---|---|
| | **30kV** | **16kV** | **8kV** | **5kV** |
| **0 degrees** | 1.3 | 1.2 | 0.9 | 0.7 |
| **15 degrees** | 1.6 | 1.4 | 1.1 | 0.8 |
| **30 degrees** | 2.5 | 2.3 | 1.9 | 1.6 |
| **45 degrees** | 4.6 | 4.1 | 3.5 | 2.9 |

Table 1 shows that sputter rates increase with angle of incidence and with beam energy. Applicants found that deposits at angles of 30 degrees or less were relatively smooth at all beam energies. Deposit at 45 degrees and beam energies of 30 kV and 16 kV showed substantial asymmetry. At 45 degrees and 8 kV, the deposit was less rough, but still not entirely smooth. At 5 kV and 45 degrees, the deposit was smooth. So in accordance with one embodiment of the invention, the FIB column can be fixed to a 45 degree angle from the sample surface and by reducing the ions landing energy to 5 kV, the reduction in the actual sputtering compared to higher beam energies increases throughput of the protective layer deposition process from about 2.5 minutes to 35 seconds. Furthermore, there is less damage to the sample surface at lower beam energies. Materials sputter rate increases with the angle of incidence but the sputter rate of 5kV landing energy is low enough to reduce material sputtering even at higher angles of incidence.

As can be seen in Table 1, as the incidence angle of the Ga+ beam approaches 45 degrees at 30 kV and 16 kV landing energy, respective, the high sputter rates are 4.6 and 4.1 atoms per ion which produce non-uniform lamella protection layers that are unusable for TEM preparation and use.

FIG. 8 shows line deposits 802, 804, 806, and 808, resulting from a Ga+ beam 810 at a 45 degree angle of incidence scanning along the longitudinal axis of the line deposit at landing energies of 5 keV, 8 keV, 16 keV, and 30 keV, respectively. The deposit 806 and 808 at 16 keV and 30 keV are sufficient rough to cause artifacts when used as a protective layer in the preparation of a TEM lamella. The deposit 804 at 8 keV, while acceptable for some application, is still somewhat rough.

Embodiments of the current invention provide deposition solutions wherein the deposition growth is symmetric. This is done by using a low landing energy, such as less than 10 keV, less than 8 keV, less than 6 keV, or preferably about 5 keV for an incidence angle of preferably greater than 30 degrees or greater than 40 degrees.

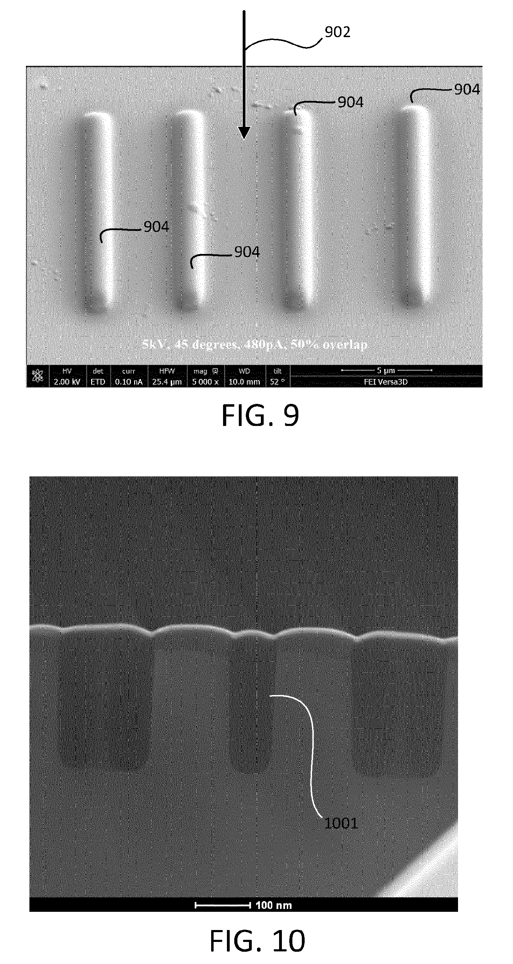

FIG. 9 shows that such scanning and beam energy produces a smooth and symmetric deposit even at a 45 degree incident angle from direction 902. FIG. 9 shows deposits 904 made using 5 keV landing energy at a 45 degree incident angle having 480pA with a 50% overlap rate between beam spots during patterning. Such beam parameters provide a uniform deposit that is useful for lamella production. The beam preferably scans in the direction of the long axis of the deposit, as shown in FIG. 5. In some embodiments, the beam is defocused during deposition. The amount of defocus varies from 10 µm to 50 µm and is preferably 50 µm.

FIG. 10 shows an image of a polished lamella formed using a 45 degree incident angle with a low 5 kV landing energy to deposit a protective layer in accordance with embodiments of the current invention. With the parameters for a symmetric deposition established, the use of a non-orthogonal angle produces smooth, uniform edges and as can be shown by walls 1001 -- there is no curtaining of the side walls of the lamella. The results also show much improved speeds of processing at 30 seconds per lamella protection layer deposition vs. 2 minutes and 10 seconds in the prior art. Thus, the use of the low landing energy at a 45 degree incident angle with the parameters of the current invention shows that the top part of the lamella is smooth, the curtaining risk is low, and the processing speed is much improved over prior art methods.

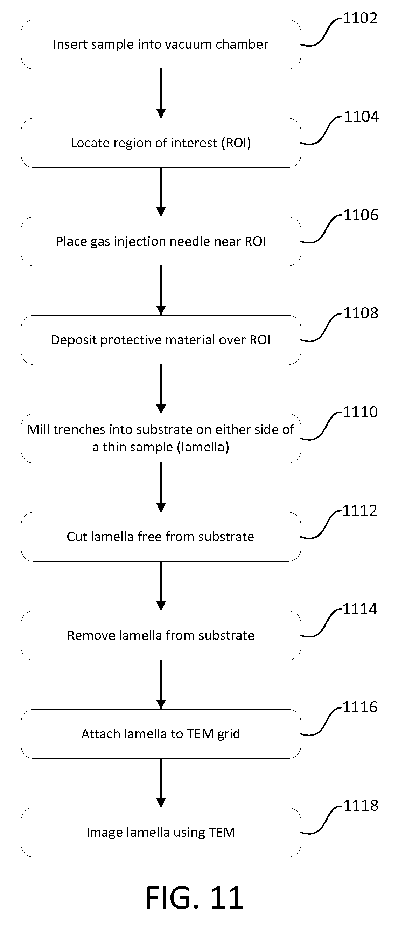

FIG. 11 shows a flow chart for the formation of a lamella using an ion beam system. In step 1102, a sample is first introduced into a vacuum chamber having an ion beam system. If the chamber was vented to introduce the sample, the vacuum is restored before proceeding. A region of interest is located on the sample in step 1104, often by imaging using a charged particle beam, although other methods can be used. Gas injection systems are used in step 1106 to introduce gases near the region of interest. The precursor gases may be decomposed by the ion beam to deposit material in step 1108. The material deposited is chosen to have properties which allow the deposit to protect the lamella as it is formed from the substrate. To form the lamella, substrate material is milled away in step 1110 from either side of the lamella, leaving a thin section. The lamella is often left attached by tabs of substrate material. In an in-situ procedure, the lamella is attached to a microprobe inside the vacuum chamber. The lamella can then be detached in step 1112, either by movement of the microprobe or by milling away the tabs attaching the lamella to the substrate. In an ex-situ procedure, the lamella attachment tabs are cut free, and the substrate is removed from the vacuum chamber for further processing. In either case, the lamella is removed in step 1114 from the substrate and attached in step 1116 to a TEM grid for imaging 1118 in a TEM. It is important to form a smooth and uniform deposit during step 1108 so that the lamella produced does not feature curtaining artifacts.

The preferred process parameters depend on the application and skilled persons can determine optimum beam energy for any incident angle and ion species. For an angle of 45 degrees, the preferred beam energy for a gallium ion beam is between 1 keV and 20 keV, more preferably between 2 keV and 10 keV, even more preferably between 3 keV and 8 keV, and most preferably between 4 keV and 6 keV. The preferred beam current any of these energies is between 200 pA and 600 pA. Any deposition precursor, such as a metallo-organic precursor or a carbon precursor such as styrene, can be used. The preferred vacuum chamber pressure when the deposition gas is present depends on the gas, but is typically between 10⁻⁵ Torr and 3x10⁻⁵ Torr.

After the lamella is prepared, it is mounted in a TEM sample grid for viewing. The removal of the lamella from the sample can be performed "ex-situ," that is, outside of the vacuum chamber or the lamella can be removed inside the vacuum chamber and mounted to a grid using ion beam deposition. For ex-situ removal, many lamellae can be prepared on a single sample, which is then removed from the vacuum chamber. The lamella can be removed from the sample and placed onto TEM sample grids. The process described above can be automated to prepare in the vacuum chamber multiple lamellae at various designated locations for ex-situ removal.

While an example of suitable hardware is provided above, the invention is not limited to being implemented in any particular type of hardware.

Preferred embodiments of the present invention also make use of a particle beam apparatus, such as an FIB or SEM, in order to image a sample using a beam of particles. Such particles used to image a sample inherently interact with the sample resulting in some degree of physical transformation. Further, throughout the present specification, discussions utilizing terms such as "calculating," "determining," "measuring," "generating," "detecting," "forming," or the like, also refer to the action and processes of a computer system, or similar electronic device, that manipulates and transforms data represented as physical quantities within the computer system into other data similarly represented as physical quantities within the computer system or other information storage, transmission or display devices.

The invention has broad applicability and can provide many benefits as described and shown in the examples above. While the examples provided described providing a protective layer for lamella formation, the invention is useful for any application of beam-induced deposition with a non-orthogonal beam. The embodiments will vary greatly depending upon the specific application, and not every embodiment will provide all of the benefits and meet all of the objectives that are achievable by the invention. Particle beam systems suitable for carrying out the present invention are commercially available, for example, from FEI Company, the assignee of the present application.

Although much of the previous description is directed at semiconductor wafers, the invention could be applied to any suitable substrate or surface. Further, whenever the terms "automatic," "automated," or similar terms are used herein, those terms will be understood to include manual initiation of the automatic or automated process or step. Whenever a scan or image is being processed automatically using computer processing, it should be understood that the raw image data can be processed without ever generating an actual viewable image. The term "image" is used in a broad sense to include not only a displayed image showing the appearance of the surface, but also to include any collection of information characterizing the multiple points on or below a surface. For example, a collection of data corresponding to the secondary electrons collected when a particle beam is at different point on a surface is a type of "image," even if the data is not displayed. Collecting information about points on the sample or sample is "imaging."

In the following discussion and in the claims, the terms "including" and "comprising" are used in an open-ended fashion, and thus should be interpreted to mean "including, but not limited to ...." The term "integrated circuit" refers to a set of electronic components and their interconnections (internal electrical circuit elements, collectively) that are patterned on the surface of a microchip. The term "semiconductor device" refers generically to an integrated circuit (IC), which may be integral to a semiconductor wafer, separated from a wafer, or packaged for use on a circuit board. The term "FIB" or "focused ion beam" is used herein to refer to any collimated ion beam, including a beam focused by ion optics and shaped ion beams.

To the extent that any term is not specially defined in this specification, the intent is that the term is to be given its plain and ordinary meaning. The accompanying drawings are intended to aid in understanding the present invention and, unless otherwise indicated, are not drawn to scale.

In a preferred embodiment, a method of charged particle beam induced deposition is used, comprising:
directing a charged particle beam toward a work piece surface at an angle of greater than 30 degrees from a surface normal, the charged particles having a landing energy of 10 keV or less; and
providing a precursor gas at the impact point of the charged particle beam, the precursor gas decomposing in the presence of the charged particle beam to deposit material onto the work piece.

In some embodiments, directing a charged particle beam toward a work piece surface comprises scanning the charged particle beam in a direction along a normal projection of the beam onto the work piece.

In some embodiments, providing a precursor gas at the impact point of the charged particle beam comprises providing a precursor gas that does not contain metal and that deposits carbon onto the work piece surface in the presence of the charged particle beam.

In some embodiments, providing a precursor gas at the impact point of the charged particle beam comprises providing a metallo-organic compound.

In some embodiments, directing a charged particle beam toward a work piece surface comprises directing a charged particle beam toward the work piece surface at an incident angle of greater than 40 degrees from a surface normal, the charged particles having a landing energy of 8 keV or less.

In some embodiments, directing a charged particle beam toward a work piece surface comprises directing a charged particle beam toward the work piece surface at an incident angle of 45 degrees +/- 5 degrees from a surface normal, the charged particles having a landing energy of between 3 keV and 7 keV.

In an embodiment of the invention, a TEM lamella may be prepared having a uniform deposition using a focused ion beam comprising:
directing a focused ion beam toward a work piece surface at an angle of greater than 30 degrees from a surface normal, the charged particles having a landing energy of 10 keV or less;
providing a precursor gas at the impact point of the charged particle beam, the precursor gas decomposing in the presence of the ion beam to deposit material onto the work piece; and
directing a focused ion beam toward the deposited material on the work piece to remove material from both sides of a region of interest to leave a thin lamella containing the region of interest, the deposited material protecting the thin lamella during formation.

In some embodiments, directing a charged particle beam toward a work piece comprises scanning the charged particle beam in a direction along a normal projection of the beam onto the work piece.

In some embodiments, providing a precursor gas at the impact point of the charged particle beam comprises providing a precursor gas that does not contain metal and that deposits carbon onto the work piece surface in the presence of the charged particle beam.

In some embodiments, providing a precursor gas at the impact point of the charged particle beam comprises providing a metallo-organic compound.

In some embodiments, directing a charged particle beam toward a work piece surface comprises directing a charged particle beam toward the work piece surface at an incident angle of greater than 40 degrees from a surface normal, the charged particles having a landing energy of 8 keV or less.

In some embodiments, directing a charged particle beam toward a work piece surface comprises directing a charged particle beam toward the work piece surface at an incident angle of 45 degrees +/- 5 degrees from a surface normal, the charged particles having a landing energy of between 3 keV and 7 keV.

In an embodiment of the invention, a charged particle beam system for processing a work piece is provided, said charged particle beam system comprising:
an ion beam column oriented at least 30 degrees from the vertical;
an electron beam column oriented at least 30 degrees from the vertical;
a gas injection system for directing a precursor gas to be decomposed by the ion beam or the electron beam;
a sample stage, the sample stage capable of moving in at least two dimensions and of rotating about a vertical axis, but not capable of tilting;
a controller for controlling the operation of the charged particle beam system in accordance with stored instructions; and
a memory for storing computer instructions for performing the methods described above.

In some embodiments, the ion beam column is oriented at least 45 degrees plus or minus 10% from the vertical.

In some embodiments, the ion beam column includes a liquid metal ion source.

In some embodiments, the ion beam column includes a plasma ion source.

## Claims

1. A method of ion beam-induced deposition, comprising:
directing an ion beam (320) toward a work piece (316) surface; and
providing a precursor gas at the impact point of the ion beam, the precursor gas decomposing in the presence of the ion beam to deposit material (318) onto the work piece;
**characterized in that** directing the ion beam toward the work piece surface comprises directing the ion beam toward the work piece surface at an angle of greater than 30 degrees from a surface normal with the ions in the beam having landing energies of 10 keV or less.

2. The method of claim 1 further comprising directing an ion beam toward the deposited material on the work piece to remove material from both sides of a region of interest to leave a thin lamella containing the region of interest, the deposited material protecting the thin lamella during formation.

3. The method of claim 1 or claim 2 in which the material deposited onto the work piece comprises a deposit having a long axis (410) and in which directing an ion beam toward the work piece comprises scanning the beam in a direction transverse to the long axis of the deposit to deposit material onto the work piece.

4. The method of any of claims 1 - 3 in which directing an ion beam toward a work piece surface comprises scanning the ion beam primarily in a direction (412) along a normal to a line containing the projection of the ion beam onto the work piece.

5. The method of any of claims 1 - 4 in which providing a precursor gas at the impact point of the ion beam comprises providing a precursor gas that does not contain metal and that deposits carbon onto the work piece surface in the presence of the ion beam.

6. The method of any of claims 1 - 4 in which providing a precursor gas at the impact point of the ion beam comprises providing a metalloorganic compound.

7. The method of any of claims 1 - 6 in which directing an ion beam toward a work piece surface comprises directing an ion beam toward the work piece surface at an incident angle of greater than 40 degrees from a surface normal, the ion in the beam having landing energies of 8 keV or less.

8. The method of any of claims 1 - 7 in which directing an ion beam toward a work piece surface comprises directing an ion beam toward the work piece surface at an incident angle of 45 degrees +/- 5 degrees from a surface normal, the ions having landing energies of between 3 keV and 7 keV.

9. The method of any of claims 1 - 8 in which directing an ion beam toward a work piece surface comprises directing an ion beam that is focused above or below the work piece surface.

10. A charged particle beam system for processing a work piece (112, 210, 3016, 408, 704), comprising:
an ion beam column (304) oriented at least 30 degrees from the vertical;
an electron beam column (302) oriented at least 30 degrees from the vertical;
a gas injection system (322) for directing a precursor gas to be decomposed by the ion beam or the electron beam;
a sample stage (314), the sample stage capable of moving in at least two dimensions and of rotating about a vertical axis, but incapable of tilting;
a controller (308) for controlling the operation of the charged particle beam system in accordance with stored instructions;
a memory (310) for storing computer instructions for controlling the charged particle beam system; and
**characterized in that** the memory for storing computer instructions for controlling the charged particle beam system stores instructions for performing the method of any of claims 1-8.

11. The charged particle beam system of claim 10 in which the ion beam column is oriented at 45 degrees plus or minus 10% from the vertical.

12. The charged particle beam system of claim 10 or claim 11 in which the ion beam column includes a liquid metal ion source.

13. The charged particle beam system of any of claims 10 - 12 in which the ion beam column includes a plasma ion source.
